# EUROPEAN PATENT APPLICATION

(11) **EP 4 306 962 A1**
(43) Date of publication of application: **17.01.2024**
(21) Application number: 21930317.9
(22) Date of filing: 25.11.2021
(51) Int. Cl.: G01N 35/00, G01N 21/01

(54) **LIGHT SOURCE AND AUTOMATIC ANALYSIS DEVICE**

(30) Priority: 08.03.2021 JP 2021036070
(71) Applicant: HITACHI HIGH-TECH CORPORATION, Tokyo 105-6409 (JP)
(72) Inventor: ARITA, Shohei, Tokyo 105-6409 (JP); MATSUOKA, Yuya, Tokyo 105-6409 (JP); ANDO, Takahiro, Tokyo 105-6409 (JP); KETA, Yasuhiro, Tokyo 105-6409 (JP)
(74) Representative: MERH-IP Matias Erny Reichl Hoffmann Patentanwälte PartG mbB
(86) International application number: PCT/JP2021/043173
(87) International publication number: WO 2022/190471

(57) **Abstract**

There is provided an automatic analyzer that keeps a temperature of a light emitting element of a light source constant and has high accuracy analysis performance. A light source for an automatic analyzer includes: a substrate including a light source; a temperature adjustment unit configured to adjust a temperature of the light source; a first optical element configured to emit light from the light source to an outside; and a member configured to cover the light source, in which the temperature adjustment unit, the substrate, the member, and the first optical element are arranged in this order, the optical element is assembled so as to be accommodated in the member, and the temperature adjustment unit puts the light source, the member, and the optical element under the same temperature control.

## Description

### Technical field

The present invention relates to a light source and an automatic analyzer that uses the light source.

### Background Art

In an automatic analyzer used for analyzing amounts of components contained in a biomaterial sample, in general, an analysis has been made in such a manner that a sample and a reagent are mixed with each other, and an inspection item is analyzed based on optical properties such as absorbance, fluorescence, and luminescence. Recently, as a light source that can be used in an absorbance analysis, a light emitting diode (hereinafter simply referred to as LED) that is expected to have a long life has been studied. For example, patent literature 1 discloses the configuration that multiplexes a halogen lamp light and an ultraviolet light of an LED using a filter.

### Citation List

### Patent Literature

PTL 1: Japanese Unexamined Patent Application Publication No. 2018-105739

### Summary of Invention

### Technical Problem

In an absorbance analysis performed using an automatic analyzer, to obtain a constant amount of light from a light source, it is necessary to set a temperature of a light emitting element constant. In PTL 1, the configuration is disclosed where a lower surface of a package of an LED is cooled or a temperature of the lower surface is made constant. However, in PTL 1, an influence of an ambient temperature to an upper surface side of the LED is not taken into consideration.

The present invention has been made in view of the above-mentioned circumstance, and it is an object of the present invention to provide a light source that makes a temperature of a light emitting element constant and possesses a highly accurate analysis performance, and an automatic analyzer that uses the light source.

### Solution to Problem

To achieve the above-mentioned object, in the present invention, there is provided a light source that includes: a substrate on which a light emitting element is placed; a temperature adjustment unit disposed so as to be in contact with a second side surface of the substrate opposite to a first side surface on which the light emitting element is placed and configured to adjust a temperature of the light emitting element; a first optical element configured to transmit light emitted by the light emitting element to an outside; and a member assembled to the temperature adjustment unit and configured to cover the light emitting element and the substrate, wherein the member includes a hole portion in a region through which light from the light emitting element passes, and the first optical element is assembled so as to be accommodated in the hole portion.

Further, to achieve the above-mentioned object, there is provided an automatic analyzer that includes: a light source; a reaction cell to be irradiated with light from the light source; a spectroscope configured to disperse light from the reaction cell; and a light amount measuring unit configured to measure the light from the spectroscope, wherein the light source includes: a substrate on which a light emitting element is placed; a temperature adjustment unit disposed so as to be in contact with a second side surface of the substrate opposite to a first side surface on which the light emitting element is placed and configured to adjust a temperature of the light emitting element; a first optical element configured to transmit light emitted by the light emitting element to an outside; and a member assembled to the temperature adjustment unit and configured to cover the light emitting element and the substrate, in which the member includes a hole portion in a region through which light from the light emitting element passes, and the first optical element is assembled so as to be accommodated in the hole portion.

### Advantageous Effect of Invention

According to the present invention, it is possible to provide a light source that makes a temperature of a light emitting element constant and possesses a highly accurate analysis performance, and an automatic analyzer that uses the light source.

### Brief Description of Drawings

[FIG. 1] FIG. 1 is a schematic diagram showing an example of an automatic analyzer for a biochemical examination.
[FIG. 2] FIG. 2 is a diagram showing a configuration example of an absorbance measuring unit of the automatic analyzer.
[FIG. 3] FIG. 3 is a diagram showing a configuration example of a light source unit according to a first embodiment.
[FIG. 4] FIG. 4 is a perspective view showing a configuration example of the light source unit according to the first embodiment.
[FIG. 5] FIG. 5 is a diagram showing a configuration example of a light source unit according to a second embodiment.
[FIG. 6] FIG. 6 is a diagram showing a configuration example of the light source unit according to the second embodiment.
[FIG. 7] FIG. 7 is a diagram showing a configuration example of a light source unit according to a third embodiment. Description of Embodiments

Hereinafter, a mode for carrying out the present invention is described with reference to the drawings . In this specification, the term "optical element" means a filter such as a dichroic filter, a reflector and the like besides a lens and a diffusion plate.

### [First Embodiment]

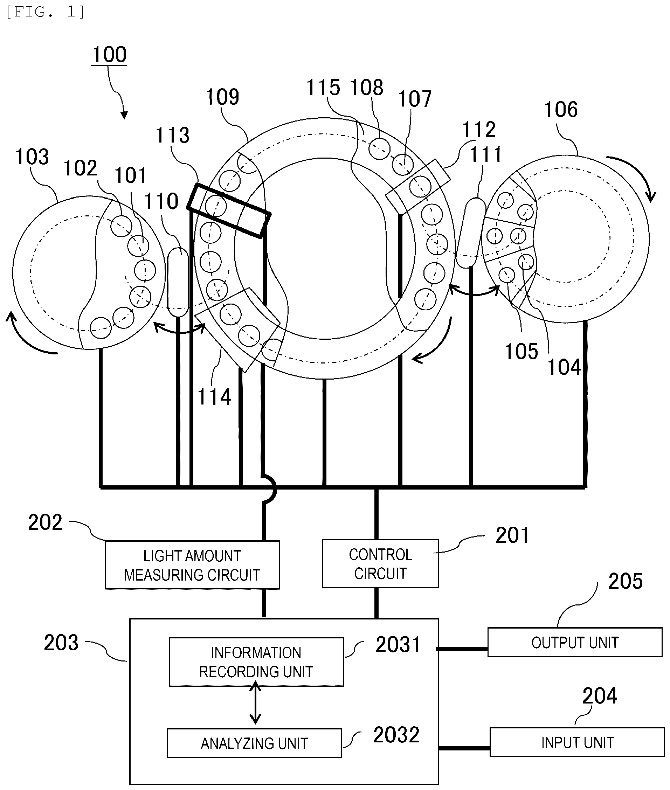

FIG. 1 is a schematic diagram showing an overall configuration of an automatic analyzer 100 for a biochemical examination according to an embodiment. The automatic analyzer 100 is a device that performs various measurements by irradiating light to a sample. The automatic analyzer 10 includes: a sample disc 103, a reagent disc 106, a reaction disc (an incubator) 109, a dispensing mechanism, a control circuit 201, a light amount measuring circuit 202, a data processing unit 203, an input unit 204, and an output unit 205. The dispensing mechanism provided to the reaction disc moves a sample and a reagent between the discs. The control circuit 201 controls the respective discs and the dispensing mechanisms . The light amount measuring circuit 202 measures absorbance of a reaction solution. The data processing unit 203 processes data that the light amount measuring circuit 202 measures. The input unit 204 and the output unit 205 are interfaces with the data processing unit 203. The dispensing mechanism includes a sample dispensing mechanism 110 and a reagent dispensing mechanism 111.

The data processing unit 203 includes an information recording unit 2031 and an analyzing unit 2032. The information recording unit 2031 is constituted of a storage memory or the like, and stores control data, measurement data, data used for data analysis, analysis result data and the like. The data processing unit 203 may be realized using a computer that is constituted of a central processing unit (CPU).

On the circumference of the sample disc 103, a plurality of sample cups 102 each being a container for a sample 101 are disposed. The sample 101 is blood, for example. On the circumference of the reagent disc 106, a plurality of reagent bottles 105 each being a container for a reagent 104 are disposed. On the circumference of the reaction disc 109, reaction cells 108 (reaction vessels) each being a container for a reaction solution 107 that is formed by mixing the sample 101 and the reagent 104 are disposed.

The sample dispensing mechanism 110 is a mechanism that is used in moving the sample 101 from the sample cup 102 to the reaction cell 108 by a fixed amount. The sample dispensing mechanism 110 is formed of, for example, a nozzle that discharges or aspirates a solution, a robot that positions the nozzle at a predetermined position or conveys the nozzle to the predetermined position, a pump that discharges a solution from the nozzle or aspirates the solution into the nozzle, and a flow path that makes the nozzle and the pump communicate with each other.

The reagent dispensing mechanism 111 is a mechanism that is used for moving a fixed amount of the reagent 104 from the reagent bottle 105 to the reaction cell 108. The reagent dispensing mechanism 111 is also formed of, for example, a nozzle that discharges or aspirates a solution, a robot that positions the nozzle at a predetermined position or conveys the nozzle to the predetermined position, a pump that discharges a solution from the nozzle or aspirates the solution into the nozzle, and a flow path that makes the nozzle and the pump communicate with each other.

A stirring unit 112 is a mechanism unit that stirs and mixes the sample 101 and the reagent 104 in the reaction cell 108. A washing unit 114 is a mechanism unit that discharges a reaction solution 107 from the reaction cell 108 where the analyzing processing is already finished and, thereafter, cleans the reaction cell 108.

In the reaction disc 109, the reaction cell 108 is immersed in a constant temperature fluid 115 in a constant temperature tank where a temperature of the constant temperature fluid is controlled. With such a configuration, the reaction cell 108 and the reaction solution 107 in the reaction cell 108 are held at a constant temperature by the control circuit 201 during the movement of the reaction disc 109. As the constant temperature fluid 115, water or air is used, for example. The absorbance measuring unit (absorbance meter) 113 that performs an absorbance analysis on the sample 101 is disposed on a portion of the circumference of the reaction disc 109.

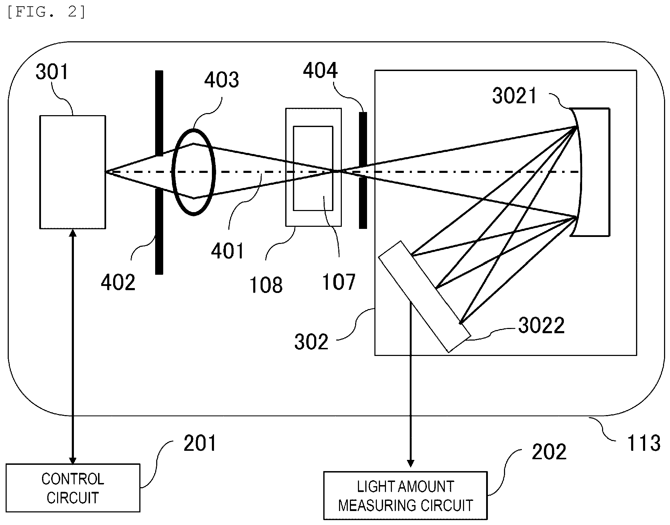

FIG. 2 is a diagram showing a configuration example of the absorbance measuring unit 113. An irradiation light generated from a light source unit 301 is emitted along an optical axis 401, is condensed by a light condensing lens 403, and is irradiated to the reaction cell 108. In such a configuration, a slit on light source side 402 may be disposed so as to make the distribution of an amount of light within a light irradiation surface uniform thus limiting a width of an emitting light from the light source unit 301.

Light that transmits the reaction solution 107 in the reaction cell 108 is dispersed by a diffraction grating 3021 in the spectroscope 302 and the dispersed lights are received by a detector array 3022 that includes a large number of optical receivers. At this point of time, light that does not transmit the reaction solution 107 becomes noise. In view of the above, the slit on spectroscope side 404 may be disposed so as to prevent such stray light from entering the spectroscope 302. Measurement wavelengths of the light that the detection array 3022 receives are, as an example, 340 nm, 376nm, 405 nm, 415 nm, 450 nm, 480nm, 505 nm, 546 nm, 570m, 600nm, 660 nm, 700 nm, and 750 nm, 800 nm and the like. These reception light signals that are received by the optical receivers are transmitted to the information recording unit 2031 of the data processing unit 203 through the light amount measuring circuit 202.

The calculation of amounts of contents of protein, sugar (glucose), lipid and the like contained in the sample 101 is carried out in accordance with the following steps. First, the control circuit 201 makes the sample dispensing mechanism 110 dispense a fixed amount of the sample 101 in the sample cup 102 into the reaction cell 108. Next, the control circuit 201 makes the reagent dispensing mechanism 111 dispense a fixed amount of the reagent 104 in the reagent bottle 105 into the reaction cell 108.

At the time of dispensing the respective solutions, the control circuit 201 rotatably drives the sample disc 103, the reagent disc 106, and the reaction disc 109 by drive units corresponding to the respective discs. In such an operation, the sample cup 102, the reagent bottle 105, and the reaction cell 108 are positioned at predetermined dispensing positions corresponding to drive timings of the respective corresponding dispensing mechanisms.

Due to the rotation of the reaction disc 109, the reaction cell 108 that accommodates the reaction solution 107 passes a measuring position where the absorbance measuring unit 113 is disposed. Each time the reaction cell 108 passes the measuring position, an amount of transmitted light from the reaction solution 107 is measured by the absorbance measuring unit 113. Measured data is sequentially outputted to the information recording unit 2031, and is stored as reaction process data.

During a period that the reaction process data is stored, if necessary, another reagent 104 is additionally dispensed into the reaction cell 108 by the reagent dispensing mechanism 111, and the measurement is further performed for a fixed time. With such an operation, the reaction process data acquired at a fixed time interval is stored in the information recording unit 2031.

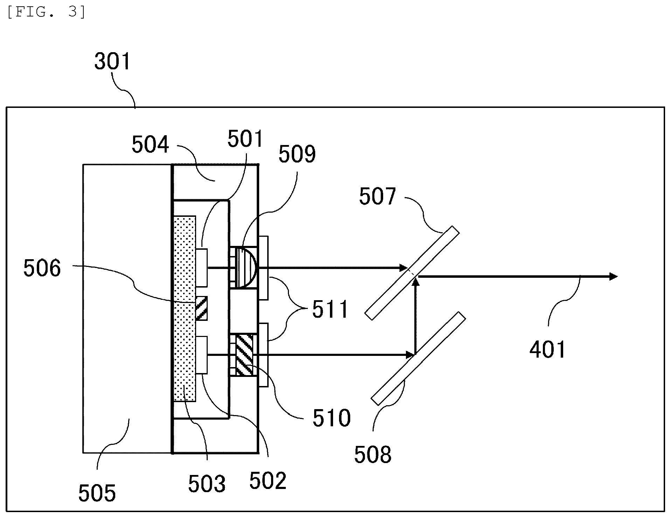

FIG. 3 is a diagram showing a configuration example of a light source of this embodiment, that is the light source unit 301. A first LED 501 and a second LED 502 are placed on an LED mounting substrate 503. The absorbance analysis requires a wide band wavelength. For example, the wide band wavelength is 340 nm to 800 nm. In view of the above, the wide band wavelength is realized by multiplexing LED lights having a plurality of different wave lengths.

In this embodiment, as shown in FIG. 3, a dichroic filter 507 is disposed on an optical path of the first LED 501 at an incident angle of 45°, and a reflector 508 is disposed on an optical path of the second LED 502 at an incident angle of 45° . Light emitted from the second LED 502 is reflected in two stages from the reflector 508 to the dichroic filter 507. Then, the light is multiplexed with light that the first LED 501 emits, and the multiplexed light is incident on the spectroscope 302 through a path of an optical axis 401.

The LED mounting substrate 503 supplies electricity to the first LED 501 and the second LED 502. The LED mounting substrate 503 is brought into contact with a temperature adjustment unit 505, and plays a role of equilibrating temperatures of the LED elements and a temperature of the temperature adjustment unit 505. A member for covering LEDs 504 is brought into contact with the temperature adjustment unit 505, sets a temperature around the LED elements constant, and suppresses a change in temperature of the LED light emitting elements generated by self-generated heat of the LEDs. As shown at an upper portion and at a lower portion of the drawing respectively, the member 504 is formed flat without forming protruding portions that protrude from an assembling surface with the temperature adjustment unit 505.

The LED mounting substrate 503 and the member for covering the LEDs 504 play a role of blocking influence of a change in an ambient temperature to the LED elements. From a viewpoint of thermal conductivity, the LED mounting substrate 503 and the member for covering the LEDs 504 are preferably made of a material that uses metal having high thermal conductivity like aluminum or copper as a base material. However, in a case where a base material such as a resin having thermal conductivity corresponding to the thermal conductivity of metal is developed in the future technical innovation, such a base material is included also in the above-mentioned base material.

By arranging a lens that forms the first optical element on the optical axis of the first LED 501, an amount of light that is incident on a light irradiation surface of the reaction cell 108 from the LED can be increased. Accordingly, a light source image of the LED light can be enlarged and hence, the distribution of an amount of light within the light irradiation surface can be made uniform. The lens may be a ball lens, a semispherical lens or the like. In this embodiment, a hemispheric lens 509 is used.

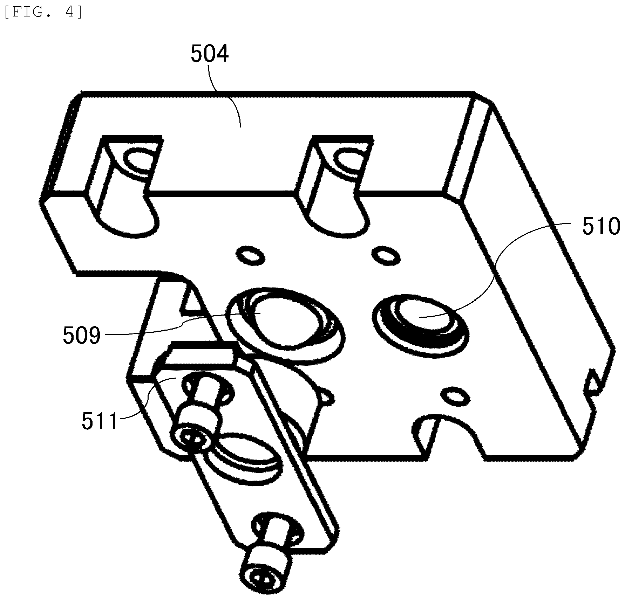

As shown in FIG. 4 that is a perspective view, the hemispheric lens 509 that forms the first optical element is assembled on the optical axis of the first LED 501 by a fixing member 511 having a pair of screws such that the hemispheric lens 509 is accommodated in the member for covering LEDs 504. By arranging the hemispheric lens 509 in the member for covering LEDs 504, a temperature of the hemispheric lens 509 is controlled to a fixed temperature thus reducing an influence of thermal deformation on the hemispheric lens 509.

To realize a highly accurate analysis in the absorbance analysis performed by the automatic analyzer 100 of the present embodiment, within the light irradiation surface of the reaction cell 108, it is necessary that the distribution of an amount of light is made uniform between the first LED 501 and the second LED 502. However, to make the distribution of an amount of light uniform between the first LED 501 and the second LED 502, a high design tolerance is required. The high design tolerance is required with respect to, for example, the mounting position of the first LED 501 and the second LED 502, an interval, and tolerances of members for holding the dichroic filter 507 and the reflector 508 and the like.

Accordingly, in this embodiment, an emitted light of the second LED is diffused, the emitted light is reflected in two stages by the dichroic filter 507 and the reflector 508, and thereafter, the distribution of an amount of the emitted light of the second LED 502 that is incident on the reaction cell 108 is made uniform. Accordingly, to diffuse the light, a diffusion plate 510 that forms the second optical element is assembled to the member 504 that covers the second LED 502 on the optical axis of the second LED 502 by fixing members 511.

In this embodiment, the configuration has been described where the lens is disposed on the optical axis of the first LED as the first optical element, and the diffusion plate is disposed on the optical axis of the second LED as the second optical element. However, it may be possible to adopt the configuration where the diffusion plate is disposed on the optical axis of the first LED as the first optical element, and the lens is disposed on the optical axis of the second LED as the second optical element, the configuration where the lens is disposed on the optical axes of both LEDs, or the configuration where the diffusion plate is disposed on the optical axes of both LEDs.

In this embodiment, a temperature that is set in the temperature adjustment unit 505 is 37 °C, for example. By controlling the temperature adjustment unit 505 in accordance with a temperature acquired by a temperature sensor 506 disposed in the temperature adjustment unit 505 or in the vicinity of the LED mounting substrate 503, the respective LED elements are held at a fixed temperature. The temperature sensor 506 is, for example, a thermistor, a thermocouple, a temperature measurement resistor or the like.

As the temperature adjustment unit 505, for example, a metal block through which a constant temperature fluid flows or a Peltier element can be used. In a case where a Peltier element is used, by performing a feedback control using the temperature sensor 506, a temperature on an LED side of the temperature adjustment unit 505, that is, a temperature on a back surface of the LED mounting substrate 503 can be controlled to, for example, approximately 37 ± 0.01 °C via the control circuit 201.

That is, as the most preferred first embodiment, there is provided the light source that includes: the substrate that has the light emitting elements; the temperature adjustment unit that adjusts the temperature of the light emitting elements; the first optical element that emits light from the light emitting element to the outside; and the metal member that covers the light emitting elements, wherein the temperature adjustment unit, the substrate, the metal member, and the first optical element are arranged in this order, and the first optical element is assembled so as to be accommodated in the metal member, and the light emitting element, the metal member, and the first optical element are under the same temperature control by the temperature control unit. In the most preferred first embodiment, there is also provided the automatic analyzer that uses such a light source.

According to the configuration of the light source and the configuration of the automatic analyzer of the first embodiment described above, an element temperature of the first LED 501 and an element temperature of the second LED 502 become substantially equal within a fixed range and hence, a quantitative analysis with high accuracy can be realized when the automatic analyzer 100 carries out a dual-wavelength measurement method.

### [Second Embodiment]

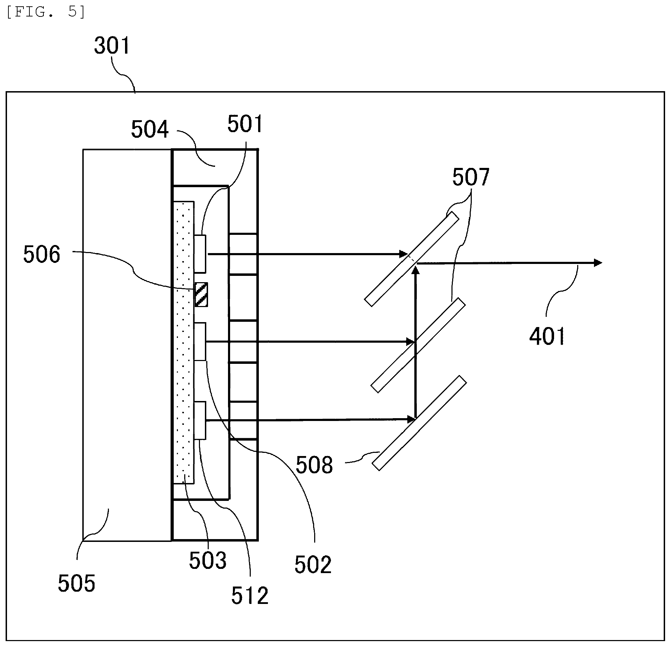

In the first embodiment, there is shown the light source having the configuration where two LEDs are mounted on the LED mounting substrate 503. However, the number of LEDs mounted on the LED mounting substrate 503 is not limited, and also neither the number of lenses nor the number of diffusion plates is limited. FIG. 5 shows one constitutional example of a light source unit 301 that automatic analyzer 100 according to the second embodiment includes. In this embodiment, a mode is described where three LEDs 501, 502, 503 are mounted on an LED mounting substrate 503, and neither a lens that forms a first optical element nor a diffusion plate that forms a second optical element is provided. Other configurations are substantially equal to the corresponding configurations of the first embodiment.

As described above, a wide band wavelength is necessary in an absorbance analysis. According to the present embodiment, a wide band wavelength can be obtained more easily by making use of three LEDs that have different wavelengths from each other and hence, an amount of light can be increased.

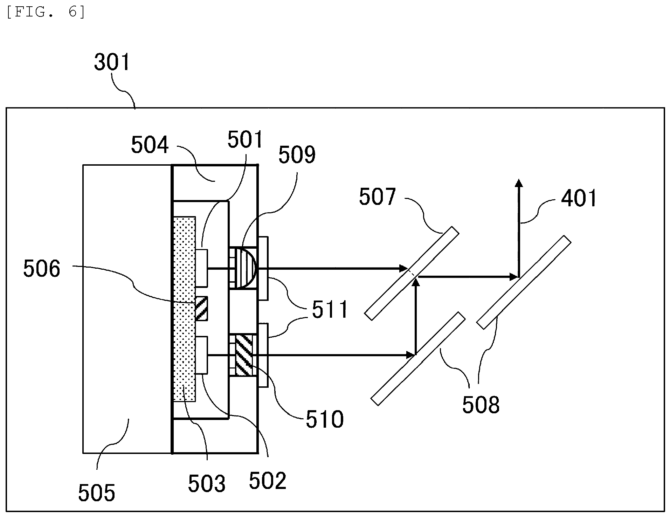

It is unnecessary to emit a multiplexed light parallel to a light of the first LED. For example, as shown in FIG. 6, a multiplexed light may be reflected on a reflector 508 thus forming a desired optical path.

### [Third Embodiment]

In the first embodiment, the mode is described where the hemispheric lens 509 is assembled to the member for covering the LEDs 504 such that the hemispheric lens 509 is accommodated in the member for covering the LEDs 504, and a temperature control is performed so as to keep the temperature of the light source unit at a constant temperature. However, what is assembled to the member for covering the LEDs 504 is not limited to the semispherical lens, and various optical elements or optical parts may be assembled to the member for covering the LEDs 504. For example, as an example of other optical parts, a dichroic filer or a reflector can be used.

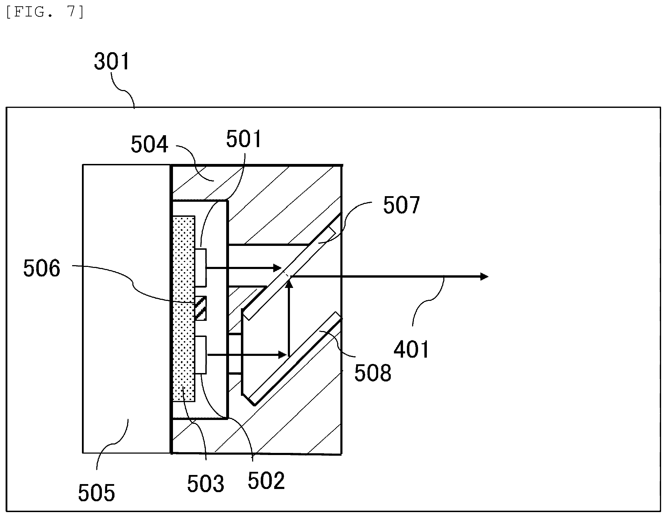

FIG. 7 is a view showing one constitutional example of a light source unit according to a third embodiment. In this constitutional example, besides a first LED 501, a second LED 502 and an LED mounting substrate 503, a dichroic filter 507 and a reflector 508 are also assembled to a member for covering LEDs 504, and a temperature control is performed so as to keep the temperature of the light source unit at a constant temperature.

The present invention is not limited to the embodiments described above and includes various modifications. For example, the above-mentioned embodiments are described in detail to facilitate the understanding of the present invention, and it is not always the case that the present invention includes all the configurations described above. Further, a portion of the configuration of one embodiment may be exchanged with the configuration of other embodiment, or the configuration of other embodiment may be added to the configuration of one embodiment. Further, with respect to a portion of the configuration of each embodiment, the configuration that other embodiment includes may be added, deleted or exchanged.

### Reference Sign List

100: automatic analyzer
101: sample
102: sample cup
103: sample disc
104: reagent
105: reagent bottle
106: reagent disc
107: reaction solution
108: reaction cell
109: reaction disc
110: sample dispensing mechanism
111: reagent dispensing mechanism
112: stirring unit
113: absorbance measuring unit
114: washing unit
115: constant temperature fluid
201: control circuit
202: light amount measuring circuit
203: data processing unit
2031: information recording unit
2032: analyzing unit
204: input unit
205: output unit
301: light source unit
302: spectroscope
3021: diffraction grating
3022: detector array
401: optical axis
402: slit on light source side
403: condenser lens
404: slit on spectroscope side
501: first LED
502: second LED
503: LED mounting substrate
504: member for covering LED
505: temperature adjustment unit
506: temperature sensor
507: dichroic filter
508: reflector
509: hemispheric lens
510: diffusion plate
511: fixing member
512: third LED

## Claims

1. A light source, comprising:
a substrate on which a light emitting element is placed;
a temperature adjustment unit disposed so as to be in contact with a second side surface of the substrate opposite to a first side surface on which the light emitting element is placed and configured to adjust a temperature of the light emitting element;
a first optical element configured to transmit light emitted by the light emitting element to an outside; and
a member assembled to the temperature adjustment unit and configured to cover the light emitting element and the substrate, wherein
the member includes a hole portion in a region through which light from the light emitting element passes, and the first optical element is assembled so as to be accommodated in the hole portion.

2. The light source according to claim 1, further comprising:
a multiplexing unit configured to multiplex light transmitted through a first optical element and light transmitted through a second optical element, wherein
a first light emitting element and a second light emitting element are placed on the first side surface of the substrate, and the substrate includes the first optical element configured to transmit light emitted by the first light emitting element to the outside, and a second optical element configured to transmit light emitted by the second light emitting element to the outside,
the hole portion includes a first hole portion in a region through which the light from the first light emitting element passes and a second hole portion in a region through which the light from the second light emitting element passes, and
the first optical element is assembled so as to be accommodated in the first hole portion, and the second optical element is assembled so as to be accommodated in the second hole portion.

3. The light source according to claim 1, wherein
a material for the substrate is aluminum or copper having high thermal conductivity.

4. The light source according to claim 1, wherein
the member does not include a protruding portion on an assembling surface with the temperature adjustment unit.

5. The light source according to claim 2, wherein
the member is assembled so as to accommodate the first optical element, the second optical element, and the multiplexing unit.

6. The light source according to claim 2 or 6, wherein
the first optical element is a lens, and the second optical element is a diffusion plate.

7. An automatic analyzer, comprising:
a light source;
a reaction cell to be irradiated with light from the light source;
a spectroscope configured to disperse light from the reaction cell; and
a light amount measuring unit configured to measure the light from the spectroscope, wherein
the light source includes: a substrate on which a light emitting element is placed; a temperature adjustment unit disposed so as to be in contact with a second side surface of the substrate opposite to a first side surface on which the light emitting element is placed and configured to adjust a temperature of the light emitting element; a first optical element configured to transmit light emitted by the light emitting element to an outside; and a member assembled to the temperature adjustment unit and configured to cover the light emitting element and the substrate, in which the member includes a hole portion in a region through which light from the light emitting element passes, and the first optical element is assembled so as to be accommodated in the hole portion.

8. The automatic analyzer according to claim 7, further comprising:
a multiplexing unit configured to multiplex light transmitted through a first optical element and light transmitted through a second optical element, wherein
a first light emitting element and a second light emitting element are placed on the first side surface of the substrate, and the substrate includes the first optical element configured to transmit light emitted by the first light emitting element to the outside, and a second optical element configured to transmit light emitted by the second light emitting element to the outside,
the hole portion includes a first hole portion in a region through which the light from the first light emitting element passes and a second hole portion in a region through which the light from the second light emitting element passes, and
the first optical element is assembled so as to be accommodated in the first hole portion, and the second optical element is assembled so as to be accommodated in the second hole portion.

9. The automatic analyzer according to claim 7, wherein
a material for the substrate is aluminum or copper having high thermal conductivity.

10. The automatic analyzer according to claim 7, wherein
the member does not include a protruding portion on an assembling surface with the temperature adjustment unit.

11. The automatic analyzer according to claim 8, wherein
the member is assembled so as to accommodate the first optical element, the second optical element, and the multiplexing unit.
